# EUROPEAN PATENT SPECIFICATION

(11) **EP 2 045 917 B1**
(45) Date of publication and mention of the grant of the patent: **17.04.2013**
(21) Application number: 09000452.4
(22) Date of filing: 23.08.2000
(51) Int. Cl.: H03G 11/04

(54) **Adaptive RF amplifier prelimiter**
Adaptive RF-Verstärkervorbegrenzer
Prélimiteur adaptatif d'amplificateur RF

(30) Priority: 31.08.1999 US 386876
(43) Date of publication of application: 08.04.2009
(62) Divisional of application: 03022851.4
(73) Proprietor: INTERDIGITAL TECHNOLOGY CORPORATION, Wilmington, DE 19801 (US)
(72) Inventor: Ozluturk, Fatih. M., Port Washington, NY 11050 (US); Kiernan, Brian, Voorhees, NJ 08043 (US)
(74) Representative: Heinze, Ekkehard

(56) References cited:
- EP-A- 0 751 630
- WO-A-98/44668
- WO-A-99/18686

## Description

### BACKGROUND OF THE INVENTION

### Field of the Invention

This invention generally relates to spread spectrum code division multiple access (CDMA) communication systems. More particularly, the present invention relates to a base station for adaptively limiting transmission power within CDMA communication systems.

### Description of the Prior Art

Wireless communication systems using spread spectrum modulation techniques represent the state of the art in digital communications and are increasing in popularity. In code division multiple access (CDMA) systems, data is transmitted using a wide bandwidth (spread spectrum) by modulating the data with a pseudo random chip code sequence. The advantage gained is that CDMA systems are more resistant to signal distortion and interfering frequencies in the transmission channel than communication systems using other multiple access techniques such as time division multiple access (TDMA) or frequency division multiple access (FDMA).

One indicator used to measure the performance of a communication system is the signal-to-noise ratio (SNR). At the receiver, the magnitude of the desired received signal is compared to the magnitude of the received noise. The data within a transmitted signal received with a high SNR is readily recovered at the receiver. A low SNR leads to loss of data.

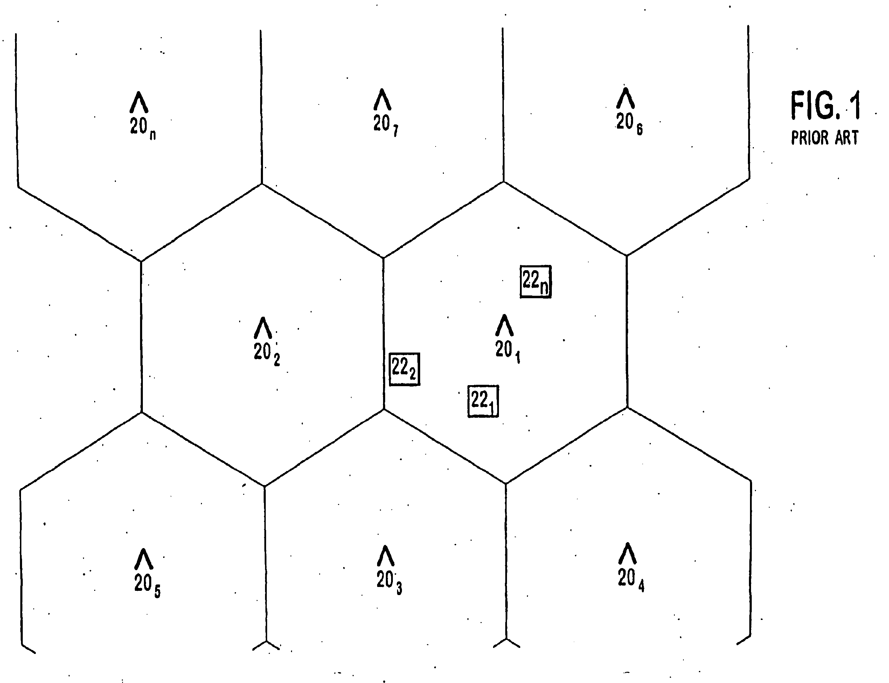

A prior art CDMA communication system is shown in **Figure 1****.** The communication system has a plurality of base stations 20₁, 20₂ ... 20_{N} connected together through a local Public Switched Telephone Network (PSTN) exchange. Each base station **20**₁, **20**₂ ... **20**_{N} communicates using spread spectrum CDMA with mobile and fixed subscriber units **22**₁, **22**₂ ... **22**_{N} within its cellular area.

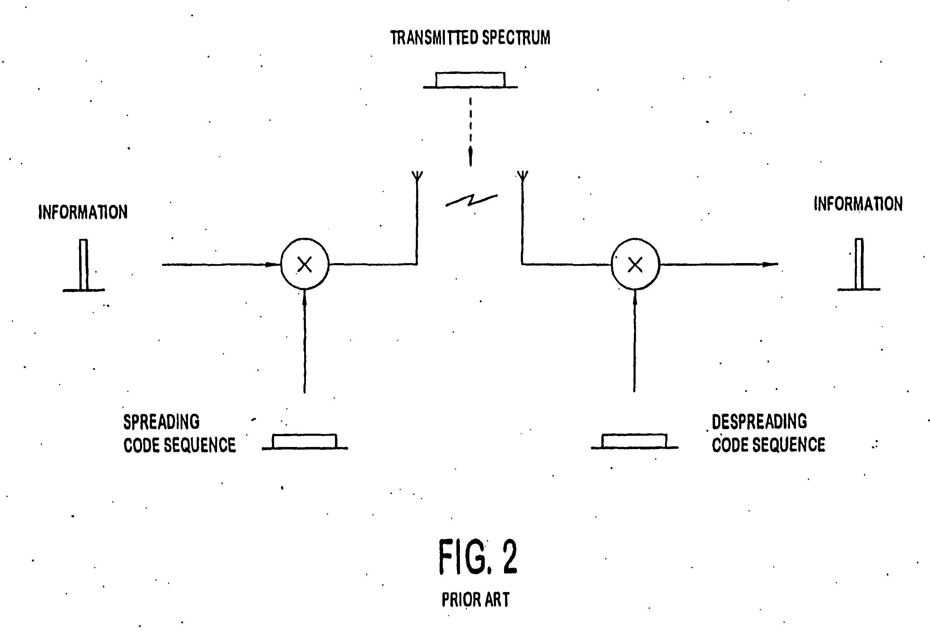

Shown in **Figure 2** is a simplified CDMA transmitter **24** and receiver **26**.. A data signal having a given bandwidth is mixed with a spreading code generated by a pseudo random chip code sequence generator producing a digital spread spectrum signal for transmission. Upon reception, the data is reproduced after correlation with the same pseudo random chip code sequence used to transmit the data. By using different pseudo random chip code sequences, many data signals or subchannels can share the same channel bandwidth. In particular, a base station **20**, can communicate with a group of subscriber units **22**₁, **22**₂ ... **22**_{N} using the same bandwidth. Forward link communications are from the base station **20**₁ to the subscriber unit **22**₁, **22**₂ ... **22**_{N}, and reverse link communications are from the subscriber unit **22**₁, **22**₂ ... **22**_{N} to the base station **20**₁.

For timing synchronization with a receiver **26**, an unmodulated pilot signal is used. The pilot signal allows respective receivers **26** to synchronize with a given transmitter **24**, allowing despreading of a traffic signal at the receiver **26**. In a typical CDMA system, each base station **20**₁, **20**₂ ... **20**_{N} sends a unique global pilot signal received by all subscriber units **22**₁, **22**₂ ... **22**_{N} within communicating range to synchronize forward link transmissions. Conversely, in some CDMA systems for example in the B-CDMA™ air interface each subscriber unit **22**₁, **22**₂ ... **22**_{N} transmits a unique assigned pilot signal to synchronize reverse link transmissions.

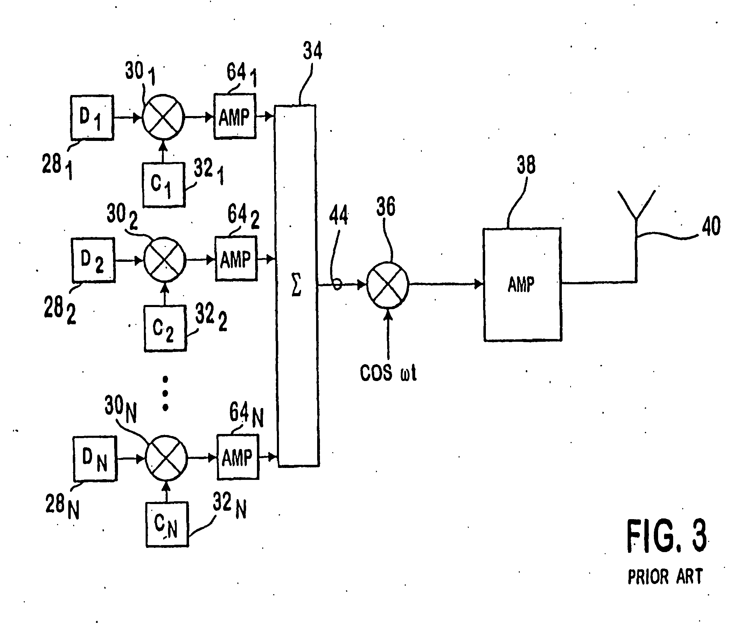

**Figure 3** is an example of a prior art transmitter **24**. Data signals **28**₁, **28**₂ ... **28**_{N} including traffic, pilot and maintenance signals are spread using respective mixers **30**₁, **30**₂ ... **30**_{N} with unique chip code sequences **32**₁, **32**₂ ... **32**_{N}, respectively. Each mixers' output is coupled to a combiner **34** which adds the individual mixed signals as a combined signal **44**. The combined signal **44** is modulated up to radio frequency (RF) by a mixer 36 mixing the combined signal **44** with an RF carrier, shown in **Figure 3** as COS ωt. The modulated signal is amplified to a predetermined transmission power level (TLP) by an amplifier **38** and radiated by an antenna **40**.

Most CDMA systems use some form of adaptive power control. In a CDMA system, many signals share the same bandwidth. When a subscriber unit **22**₁, **22**₂ ... **22**_{N} or base station **20**₁, **20**₂ ... **20**_{N} is receiving a specific signal, all the other signals within the same bandwidth are noise like in relation to the specific signal. Increasing the power level of one signal degrades all other signals within the same bandwidth. However, reducing TLP too far results in undesirable SNRs at the receivers **26**. To maintain a desired SNR at the minimum transmission power level, adaptive power control is used.

Typically, a transmitter **24** will send a signal to a particular receiver 26. Upon reception, the SNR is determined. The determined SNR is compared to a desired SNR. Based on the comparison, a signal is sent in the reverse link to the transmitter **24**, either increasing or decreasing transmitpower. This is known as forward channel power control. Conversely, power control from the subscriber unit **22**, to the base station **20**, is known as reverse channel power control.

Amplifiers **64**₁, **64**₂ ... **64**ₙ are used for adaptive power control in Figure **3**. The amplifiers **64**₁, **64**₂ ... **64**ₙ are coupled to the inputs of the combiner **34** to individually control each signal's power level.
WO 98/44668 describes a Direct Sequence Code Division Multiple Access (DS-CDMA) cellular telecommunication system wherein a cellular base station communicates with multiple mobile units while maintaining exclusive communication links with the mobile units. Each exclusive link is assigned a code that is orthogonal with all other codes. In this case, Walsh code is used, this code having the property that all its member codes are orthogonal with each other. This property of Walsh codes allows a base station in DS-CDMA system to transmit a composite of carrier signals, where each carrier signal is coded with an assigned Walsh code. Each receiving unit extracts desired information based on the assigned Walsh code and ignores other orthogonal Walsh codes.
In one particular embodiment, a peak-reducing waveform is estimated and summed with a composite signal to reduce a peak-to-average power ratio of the composite signal The estimate of the peak-reducing waveform is modified to have Walsh code components orthogonal to the assigned Walsh codes. An iterative process of estimating subsequent peak-reducing waveform is implemented to produce a peak-reducing waveform which, when summed with the composite signal, results in a composite signal having a peak-to-average power ratio at a desired level and thus does not have the effects of remodulating the assigned Walsh codes.

WO 99/18686 describes a coding and modulating system including a combined modulator/demodulator and a spreading/despreading mechanism. The spreading/despreading mechanism includes an information vector generator, a dynamic Table coupled to the output of the information vector generator, a multiplication block coupled to the output of the dynamic Table, a Walsh function generator coupled to the multiplication block, a summation block coupled to the output of the multiplication block, and a dynamic limiter for limiting the output of the summation block
EP 0 751 630 A2 describes a code division multiple access base station transmitter which is placed in a mobile communication system base station transmitting and receiving a plurality of communication channels by a direct spread code division multiple access system (DS-CDMA) and ensures suppression of transmission peak power while transmitting. The system comprises a plurality of spread units for spreading transmission data of a plurality of communication channels by different spreading codes to output spread signals, a summing synthesizer for summing up the spread signals output from the spread units to output a multiplexed spread signal, and a limiter for performing an amplitude limitation of the multiplexed spread signal output from the summing synthesizer. The system further comprises a roll-off filter for carrying out a spectrum shaping of the amplitude-limited multiplexed spread signal so that an occupied band width of the amplitude-limited multiplexed spread signal is included within a predetermined value, a digital-to-analog converter for converting a digital base band signal of the spectrum-shaped multiplexed spread signal into an analog base band signal, a modulator for converting the analog base band signal into a radio frequency signal, a transmission power amplifier for amplifying the radio frequency signal output from the modulator, and a transmission antenna for transmitting the amplified radio frequency signal output from the transmission power amplifier.

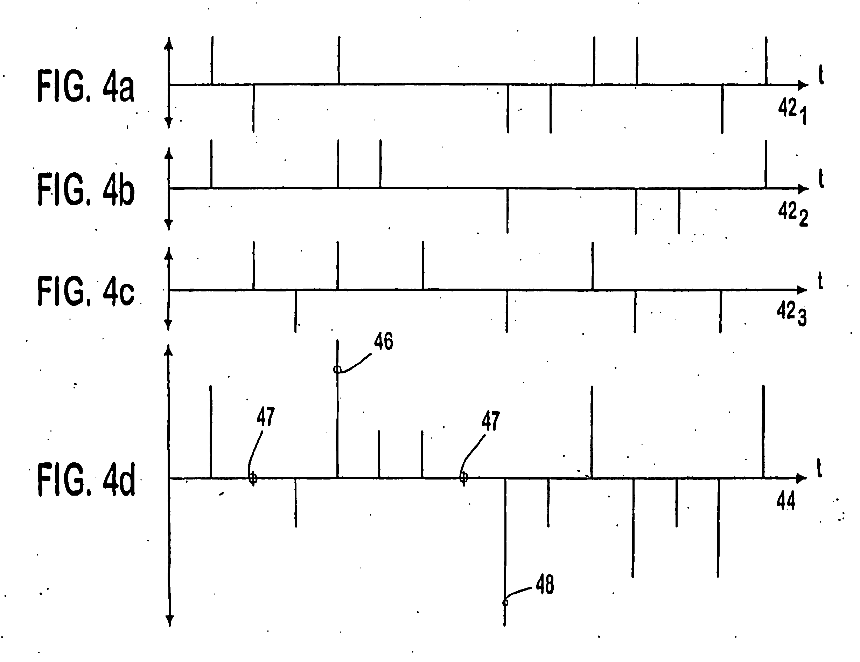

**Figure 4a, 4b, 4c and 4d** show a simplified illustration of three spread spectrum signals **42**₁, **42**₂, **42**₃ and a resultant combined signal **44**. Although each signal **42**₁, **42**₂, **42**₃ is spread with a different pseudo random chip code sequence, each signal **42**₁, **42**₂, **42**₃ is synchronous at the chipping rate. When the individual chips within the sequences are summed, the combined signal may have extreme transients 46, 48 where the chip energies combine or low transients **47** where they subtract.

High transient peaks are undesirable. For every 3 dB peak increase, twice the base amplification power in Watts is required. Not only does the transient burden the amplifier, but the power sourcing the amplifiermust have a capacity greater than the maximum transient that may be expected. This is particularly undesirable in hand-held battery operated devices. Additionally, to design for higher power levels resulting from high transients, more complex amplifier circuitry is required or compromises between amplifier gain, battery life and communication time result. High valued transients force the amplifier 38 into the nonlinear region of its dynamic range resulting in increased out-of-band emissions and reduced amplifier efficiency. Accordingly, there exists a need for an adaptive RF transmitter system that addresses the problems associated with the prior art.

### SUMMARY OF THE INVENTION

The present invention provides a base station for transmitting signals employing a code division multiple access (CDMA) technique in accordance with independent claim 1. Preferred embodiments of the invention are reflected in the dependent claims.

The claimed invention can be better understood in view of the arrangements described hereinafter. In general, the described arrangements describe preferred embodiments of the invention. The attentive reader will note, however, that some aspects of the described arrangements extend beyond the scope of the claims. To the respect that the described arrangements indeed extend beyond the scope of the claims, the described arrangements are to be considered supplementary background information and do not constitute definitions of the invention per se. This also holds for the subsequent "Brief Description of the Drawings" as well as the "Detailed Description of the Exemplary Arrangements".

In particular, according to the present invention, the base station for transmitting signals employing a CDMA technique comprises means for combining a plurality of spread spectrum data signals, wherein the output of the combining means is a combined signal having a fluctuating power level and means for modulating the combined signal to produce an RF signal for transmission. Furthermore, the base station comprises means for measuring an approximate variance, an approximation of the standard deviation, an average of a square of the output of said combining means for a given time period and means for adaptively limiting an output of the combining means to a calculated power level based at least in part on said measured average of an approximate variance, approximation of the standard deviation, or average of the square of the output of said combining means for a given time period.

The invention therefore reduces transient peaks in signals transmitted in CDMA communication systems. A plurality of spread spectrum data signals are combined into a combined signal having fluctuating power level corresponding to the combination of the data signals. The combined signal is modulated to produce an RF signal for transmission. The average power of the combined signal is measured over a selected time period. The combined signal power level is adaptively limited to a calculated power level based at least in part on the measured power.

### BRIEF DESCRIPTION OF THE DRAWINGS

**Figure 1** is an illustration of a prior art CDMA system.
**Figure 2** is an illustration of a prior art CDMA transmitter and receiver.
**Figure 3** is a system block diagram of a prior art transmitter.
**Figure 4a** is an illustration of a first pseudo random chip code sequence.
**Figure 4b** is an illustration of a second pseudo random chip code sequence.
**Figure 4c** is an illustration of a third pseudo random chip code sequence.
**Figure 4d** is an illustration of the combined chip code sequences of **Figures 4a - 4c****.**
**Figure 5** is a system block diagram of an embodiment of the invention with the power measurement device coupled to the amplifier.
**Figure 6** is a system block diagram of an alternate embodiment of the invention with the power measurement device coupled to the modulator.
**Figure 7** is an illustration ofthe probability distribution function ofthe power levels of a combined signal.
**Figure 8** is a plot of the loss in the received signal to noise ratio versus the clipping level.
**Figure 9** is a plot of the loss in the received signal to noise ratio versus the clipping level in a CDMA communication system using adaptive power control.
**Figure 10** is a system block diagram of an alternate embodiment of the invention with the processor controlling the amplifier gain.

### DESCRIPTION OF THE EXEMPLARY ARRANGEMENTS

The preferred arrangements will be described with reference to the drawing figures where like numerals represent like elements throughout.

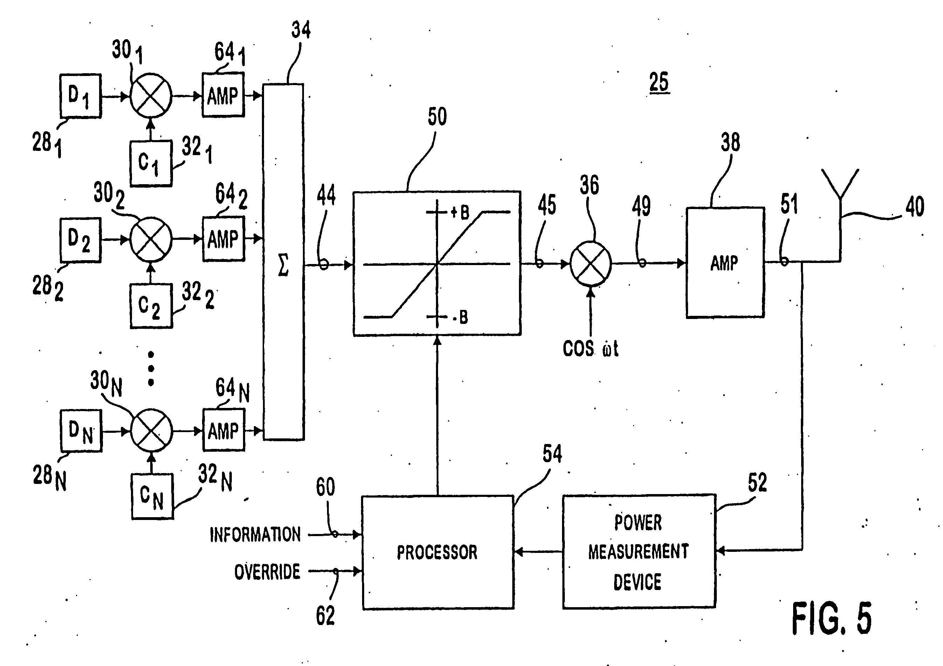

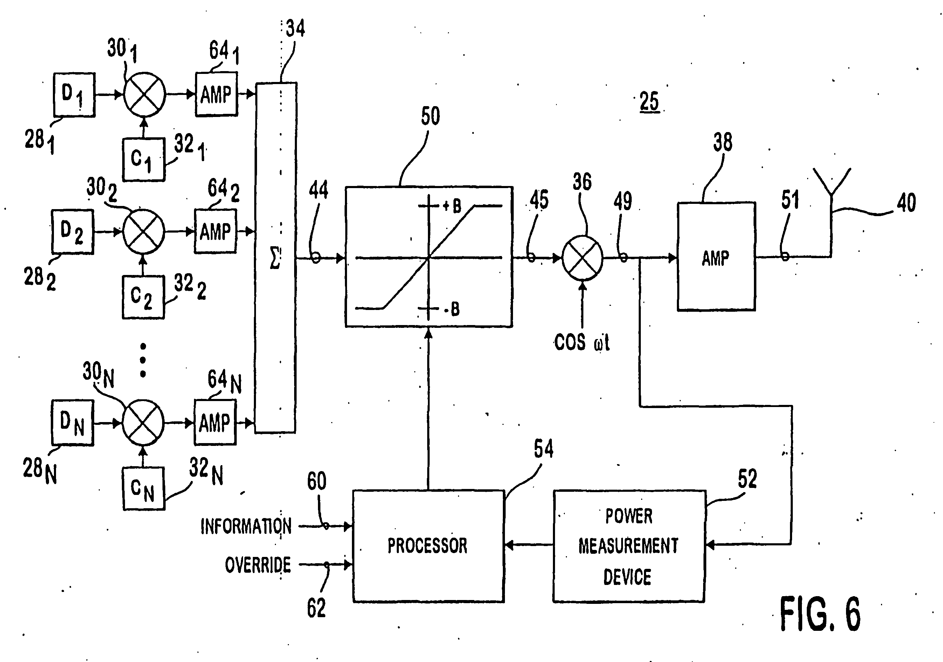

**Figures 5** **and** **6** depict transmitter systems. A group of data signals 28₁, 28₂ ... 28_{N} that include traffic, pilot and maintenance signals are mixed with different chip code sequences 32₁, 32₂ ... 32_{N} and are summed together in a combiner **34** as a combined signal **44**. The combiner 34 is coupled to an adjustable signal limiter 50 (clipper) where signal power levels are hard limited to + β and -β dB. Power levels in between +β and -β are not affected. The limited signal 45 is modulated up to RF by a mixer **36**. The modulated signal is amplified by an amplifier **38** to a predetermined power level and radiated by antenna **40**.

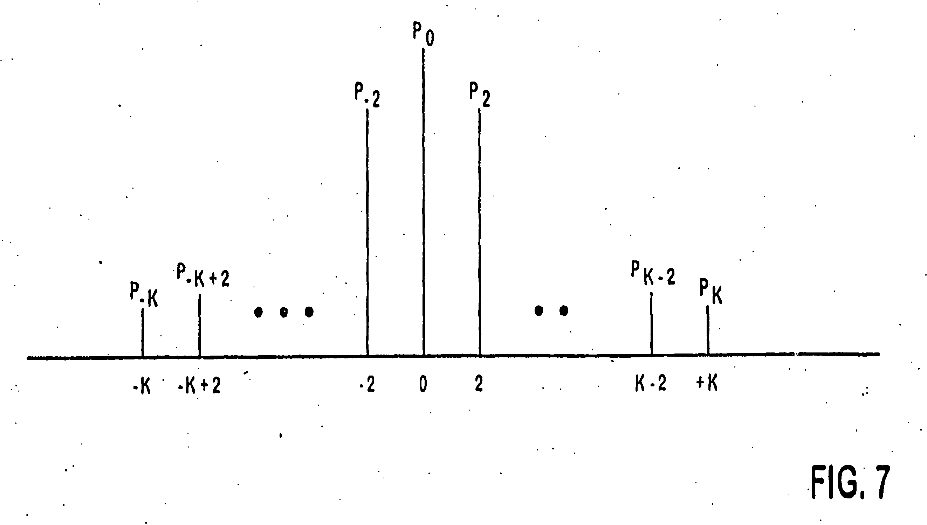

**Figure 7** illustrates atypical probability distribution function ofthe combined signal power level. A combined chip **46, 47, 48** as shown in **Figure 4d** will have an associated power level. The probability of a given combined chip having a particular power level is shown in **Figure 7**. The two extreme power levels are +K and -K. As shown in **Figure 7**, the probability of a given combined chip having a power level of +K or -K is extremely low. Whereas, the probability of a combined chip having a power level in the middle of the two extremes is high. Since a spread spectrum signal is spread across a wide communication bandwidth and there is a low probability that a combined chip will have a power level at the ends of the distribution, the combined signal **44** can be clipped below these extremes with insignificant loss.

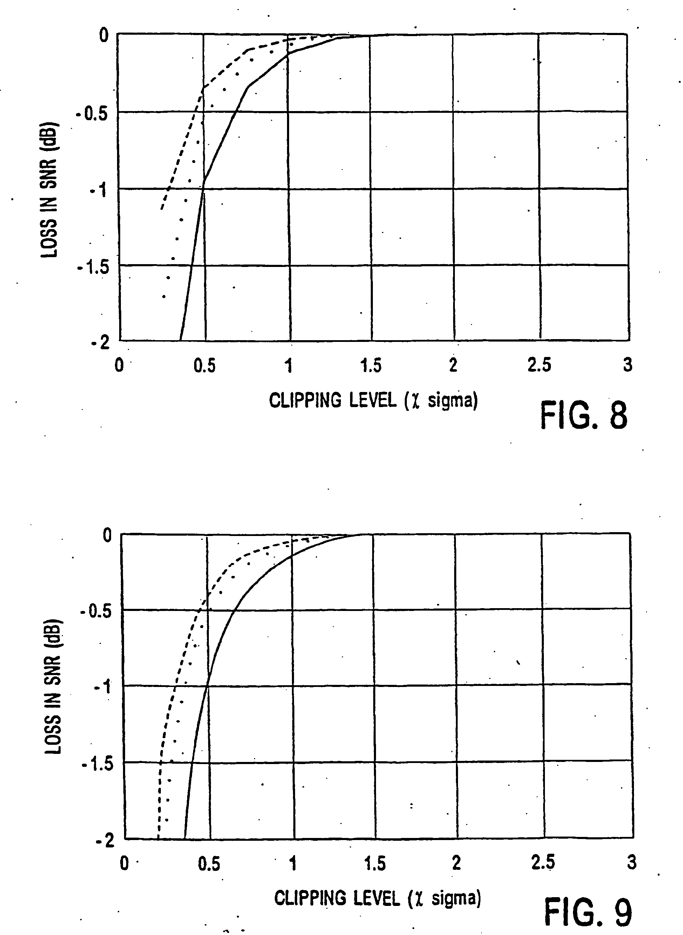

The transmitter system adjusts the clipping levels, β, to eliminate the signal transients with only a small decrease in the transmittal signal-to-noise ratio (SNR). **Figure 8** is a graph illustrating the relationship between SNR and clipping levels for a system not using adaptive power control. The solid line, dash line and dotted line depict communication channels with different operating SNRs. As shown in **Figure 8**, for a β set at a clipping level of two standard deviations the loss in SNR is negligible and at a clipping level of one standard deviation the loss is only approximately 0.2 dB.

For a system using adaptive power control, **Figure 9** is a graph of SNR. versus the clipping level. The results are similar to those obtained in a system not using adaptive power control. As shown in **Figure 9**, with a clipping level oftwo standard deviations, the loss in SNR is again negligible. Accordingly, the clipping circuitry is applicable to systems utilizing adaptive power control and systems not using adaptive power control.

Referring back to **Figure 5**, to determine β, a power measurement device 52 and a processor 54 are used. The power measurement device 52 is coupled to either the output of the RF amplifier 38 as shown in **Figure 5** or the mixer **36** as shown in **Figure 6**. Preferably, the power measurement device 52 determines the average of the square of the magnitude of the transmitted signal over a predetermined time period. The output of the preferred power measurement device 52 approximates the variance of the mixed signal **49** or the signal **51** being transmitted. Alternatively, the power measurement device 52 determines an approximation of the standard deviation by taking the average of the absolute value ofthe signal **49, 51** or the power measurement device 52 measures the magnitude of the signal **49, 51** with the processor determining either the variance or standard deviation.

The output of the power measurement device **52** is coupled to a processor **54**. If the power measurement device 52 is coupled to the output of the amplifier **38**, the processor 54 scales down the output of the power measurement device **52** by the gain of the amplifier 38. The processor 54 determines the proper clipping level for β. Depending on the desired SNR and bandwidth, the value for β will be a multiple of the standard deviation. If the power measurement device 52 approximates the variance, the processor 54 will take the square root of the device's output as the standard deviation. In a preferred arrangement β will be two times the standard deviation.

In certain situations, the processor **54** overrides the determined value of β. For instance, if the transmitter 25 was used in a base station 20₁, 20₂ ... 20_{N}, a large increase in the number of users may result in β being temporarily set too low. This will result in an undesirable received SNR. As supplied to the processor 54 through the line 60, the number of users currently in communication with the base station 20₁, 20₂ ... 20_{N}, is used to either change β or temporarily disable the clipper 50 to allow all signals to pass unaltered when appropriate.

Additionally, since the probability distribution function assumes a large sample size, a small number of users may result in an undesired received SNR. Accordingly, if only a few users were in communication with the base station 20₁, 20₂ ... 20_{N}, the clipper **50** may be disabled. In addition, when there are only a small number of users active, the amplifier's dynamic range is not reached. Accordingly, there is no need to clip the combined signal. Under other situations, it may be necessary to override the clipper 50. For instance, in some CDMA systems short codes are used during initial power ramp up. Since these codes are not long enough to approximate a random signal, by chance one code may result in a large number of high transient peaks within the signal. Clipping these transmissions may dramatically decrease the received SNR and unnecessarily delay the initial power ramp up procedure. In these situations, a signal will be sent to the processor **54** through the line 62 to override the clipper 50.

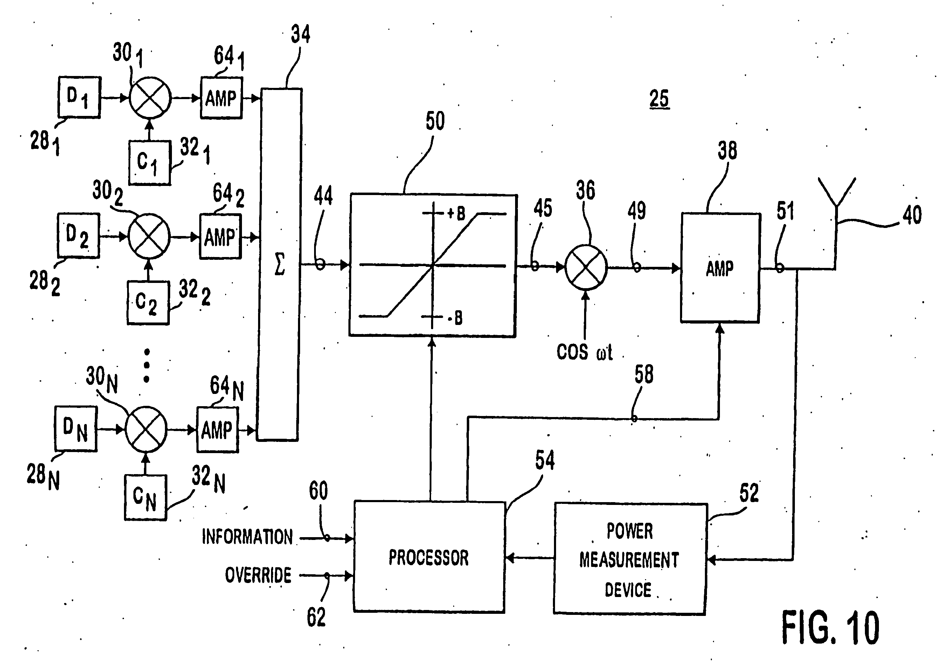

In an alternate arrangement shown in Figure 10, the processor 54 is also used to control the gain of the amplifier 38 through the line 58. Stored in the processor is the amplifier gain characteristic. The amplifier gain is adjusted to keep the amplifier from going into the nonlinear operating region. Accordingly, out-of-band emissions and interference to service in adjoining frequency bands is reduced.

Although the invention has been described in part by making detailed reference to certain specific arrangements, such detail is intended to be instructive rather that restrictive. It will be appreciated by those skilled in the art that many variations may be made in the structure and mode of operation without departing from the scope of the invention as disclosed in the teachings herein.

In a preferred aspect of the invention there is provided: a transmitter for use in a CDMA communication system station, the transmitter comprising: means for combining a plurality of spread spectrum data signals into a combined signal having a fluctuating power level corresponding to the combination of the data signals; means for modulating the combined signal to produce an RF signal for transmission; means for measuring average power of the combined signal over a selected time period; and means for adaptively limiting the combined signal power to a calculated power level based at least in part on said measured power.

The transmitter as defined above wherein said measuring means measures an average power of the RF signal over the selected time period.

The transmitter as defined above further comprising an amplifier for amplifying the RF signal prior to transmission; wherein said measuring means measures an average power of the amplified RF signal over the selected time period.

The transmitter as defined above wherein said measuring means determines a variance of the combined signal power wherein said adaptively limiting means limits the combined signal power to the calculated power level based in part on the approximation of the variance. The transmitter as defined above wherein said measuring means determines an average of a square of the combined signal power; wherein said adaptively limiting means limits the combined signal power to the calculated power level based in part on the average of the square. The transmitter as defined above wherein said measuring means determines an average of an absolute value of the combined signal power; wherein said adaptively limiting means limits the combined signal power to the calculated power level based in part on the average of the absolute value. The transmitter as defined above wherein said measuring means determines a magnitude of the combined signal power and said measuring means having processing means for determining a variance of the combined signal power based on the determined magnitude; wherein said adaptively limiting means limits the combined signal power to the calculated power level based in part on the determined variance. The transmitter as defined above wherein said measuring means having processing means for determining a standard deviation of the combined signal power and said adaptively limiting means limits the combined signal power to the calculated power level based in part on the determined standard deviation. The transmitter as defined above wherein the calculated power level is two of the determined standard deviations. The transmitter as defined above wherein the calculated power level is the determined standard deviation. The transmitter as defined above wherein said processing means disables said adaptively limited means in response to a number of active users. The transmitter as defined above wherein said processing means disables said adaptively limiting means during transmission of short codes. The transmitter as defined above further comprising an amplifier for amplifying the RF signal prior to transmission and processing means for determining the calculated power level; wherein a gain of said amplifier is adjusted by said processing means in response to the calculated power level and stored gain characteristics of said amplifier. In a preferred aspect there is also provided a method for transmission in a CDMA communication system, the method comprising: combining a plurality of spread spectrum data signals into a combined signal having a fluctuating power level corresponding to the combination of the data signals; modulating the combined signal to produce an RF signal; measuring average power of the combined signal over a selected time period; adaptively limited the combined signal power to a calculated power level based at least in part on said measured power; and transmitting the RF signal. The method as defined above wherein the measuring is of an average power of the RF signal over a selected time period. The method as defined above further comprising amplifying the RF signal prior to transmission; wherein the measuring is of an average power of the amplified RF signal over the selected time period. The method as defined above wherein the calculated power is based on a variance of the combined signal. The method as defined above wherein the calculated power is based on standard deviation of the combined signal. The method as defined above wherein the calculated power is one of the standard deviations. The method as defined above wherein the calculated power is two of the standard deviations. The method as defined above wherein the step of adaptively limiting is not performed in response to a number of active users. The method as defined above wherein the step of adaptively limiting is not performed in response a transmission of short codes. The method as defined above further comprising: amplifying by an amplifier the RF signal by a gain factor prior to transmission; and adjusting the gain factor in response to the calculated power level and stored gain characteristics of the amplifier.

## Claims

1. A base station, comprising:
a plurality of mixers (30₁- 30_{N}) configured to mix a plurality of data signals (28₁ - 28_{N}) with different code sequences (32₁ - 32_{N});
a combiner (34) configured to combine the plurality of mixed data signals to produce a combined signal (44);
an adjustable signal limiter (50) configured to produce a limited signal (45) wherein the adjustable signal limiter (50) is coupled to the output of the combiner (34);
a mixer (36) configured to modulate the limited signal (45) up to radio frequency;
a power measurement device (52) configured to measure a power of the modulated limited signal (49) over a predetermined time period;
a processor (54) configured to determine a clipping level of the adjustable signal limiter (50) based on the measured power of the modulated limited signal (49);
an amplifier (38) configured to amplify the modulated limited signal(49) to a predetermined power level to produce an amplified signal (51); and
an antenna (40) configured to transmit the amplified signal (51).

2. The base station according to claim 1, wherein the plurality of data signals (28₁ - 28_{N}) include any one of: traffic signals, pilot signals, or maintenance signals.

3. The base station according to claim 1, wherein the adjustable signal limiter (50) is configured to limit signal power levels.

4. The base station according to claim 1, wherein:
the power measurement device (52) is configured to determine an average of a square of a magnitude of a amplified signal (51) over the predetermined time period.

5. The base station according to claim 4, wherein:
the power measurement device (52) is coupled to an output of the amplifier (38) and is configured to measure a power of the amplified signal (51); and
the processor (54) is configured to determine the clipping level of the adjustable signal limiter (50) based on the measured power of the amplified signal (51).

6. The base station according to claim 5, wherein the processor (54) is configured to scale down the output of the power measurement device (52) by a gain of the amplifier(38).

7. The base station according to claim 1, wherein:
the power measurement device (52) is configured to approximate a variance of the transmitted signal (49, 51) over the predetermined time period; and
the processor (54) is configured to determine a square root of the transmitted signal as a standard deviation.

8. The base station according to claim 7, wherein the standard deviation is two times a clipping level of the adjustable signal limiter(50).

9. The base station according to claim 1, wherein the processor (54) is configured to override a determined clipping level of the adjustable signal limiter (50).

10. The base station according to claim 1, wherein the processor (54) is configured to control a gain of the amplifier (38).

11. The base station according to claim 10, wherein the gain of the amplifier (38) is adjusted to prevent the amplifier (38) from going into a nonlinear operating region.

## Patentansprüche

1. Basisstation, Folgendes umfassend:
mehrere Mischer (30₁ - 30_{N}), die dazu konfiguriert sind, mehrere Datensignale (28₁ - 28_{N}) mit verschiedenen Codesequenzen (32₁ - 32_{N}) zu mischen;
einen Kombinierer (34), der dazu konfiguriert ist, die mehreren gemischten Datensignale zu kombinieren, um ein kombiniertes Signal (44) zu erzeugen;
einen einstellbaren Signalbegrenzer (50), der dazu konfiguriert ist, ein begrenztes Signal (45) zu erzeugen, wobei der einstellbare Signalbegrenzer (50) auf den Ausgang des Kombinierers (34) aufgeschaltet ist;
einen Mischer (36), der dazu konfiguriert ist, das begrenzte Signal (45) bis auf Radiofrequenz zu modulieren;
eine Leistungsmessvorrichtung (52), die dazu konfiguriert ist, eine Leistung des modulierten begrenzten Signals (49) über einen bestimmten Zeitraum zu messen;
einen Prozessor (54), der dazu konfiguriert ist, einen Begrenzungspegel des einstellbaren Signalbegrenzers (50) auf Grundlage der gemessenen Leistung des modulierten begrenzten Signals (49) zu bestimmen;
einen Verstärker (38) der dazu konfiguriert ist, das modulierte begrenzte Signal (49) auf einen vorbestimmten Leistungspegel zu verstärken, um ein verstärktes Signal (51) zu erzeugen; und
eine Antenne (40), die dazu konfiguriert ist, das verstärkte Signal (51) zu übertragen.

2. Basisstation nach Anspruch 1, wobei die mehreren Datensignale (28₁ - 28_{N}) Verkehrssignale, Pilotsignale oder Wartungssignale enthalten.

3. Basisstation nach Anspruch 1, wobei der einstellbare Signalbegrenzer (50) dazu konfiguriert ist, Signalleistungspegel zu begrenzen.

4. Basisstation nach Anspruch 1, wobei:
die Leistungsmessvorrichtung (52) dazu konfiguriert ist, einen Mittelwert eines Quadrats einer Amplitude eines verstärkten Signals (51) über den vorbestimmten Zeitraum zu bestimmen.

5. Basisstation nach Anspruch 4, wobei:
die Leistungsmessvorrichtung (52) auf einen Ausgang des Verstärkers (38) aufgeschaltet und dazu konfiguriert ist, eine Leistung des verstärkten Signals (51) zu messen; und
der Prozessor (54) dazu konfiguriert ist, den Begrenzungspegel des einstellbaren Signalbegrenzers (50) auf Grundlage der gemessenen Leistung des verstärkten Signals (51) zu bestimmen.

6. Basisstation nach Anspruch 5, wobei der Prozessor (54) dazu konfiguriert ist, den Ausgang der Leistungsmessvorrichtung (52) um eine Verstärkung des Verstärkers (38) herabzustufen.

7. Basisstation nach Anspruch 1, wobei:
die Leistungsmessvorrichtung (52) dazu konfiguriert ist, eine Varianz des übertragenen Signals (49, 51) über den vorbestimmten Zeitraum anzugleichen; und
der Prozessor (54) dazu konfiguriert ist, eine Quadratwurzel des übertragenen Signals als Standardabweichung zu bestimmen.

8. Basisstation nach Anspruch 7, wobei es sich bei der Standardabweichung um einen zweifachen Begrenzungspegel des einstellbaren Signalbegrenzers (50) handelt.

9. Basisstation nach Anspruch 1, wobei der Prozessor (54) dazu konfiguriert ist, einen bestimmten Begrenzungspegel des einstellbaren Signalbegrenzers (50) zu übersteuern.

10. Basisstation nach Anspruch 1, wobei der Prozessor (54) dazu konfiguriert ist, eine Verstärkung des Verstärkers (38) zu regeln.

11. Basisstation nach Anspruch 10, wobei die Verstärkung des Verstärkers (38) eingestellt wird, um zu verhindern, dass der Verstärker (38) in einen nichtlinearen Betriebsbereich übergeht.

## Revendications

1. Station de base, comprenant :
une pluralité de mélangeurs (30₁ - 30_{N}) configurés pour mélanger une pluralité de signaux de données (28₁ - 28_{N}) avec différentes séquences de code (32₁ - 32_{N}) ;
un combineur (34) configuré pour combiner la pluralité de signaux de données mélangés pour produire un signal combiné (44) ;
un limiteur de signal réglable (50) configuré pour produire un signal limité (45), où le limiteur de signal réglable (50) est couplé à la sortie du combineur (34) ;
un mélangeur (36) configuré pour moduler le signal limité (45) jusqu'à la fréquence radio ;
un appareil de mesure de puissance (52) configuré pour mesurer une puissance du signal limité modulé (49) sur une période de temps prédéterminée ;
un processeur (54) configuré pour déterminer un niveau d'écrêtage du limiteur de signal réglable (50) sur la base de la puissance mesurée du signal limité modulé (49) ;
un amplificateur (38) configuré pour amplifier le signal limité modulé (49) à un niveau de puissance prédéterminé pour produire un signal amplifié (51) ; et
une antenne (40) configurée pour transmettre le signal amplifié (51).

2. La station de base selon la revendication 1, où la pluralité de signaux de données (28₁ - 28_{N}) inclut n'importe lequel de : signaux de trafic, signaux pilotes, ou signaux de maintenance.

3. La station de base selon la revendication 1, où le limiteur de signal réglable (50) est configuré pour limiter des niveaux de puissance de signal.

4. La station de base selon la revendication 1, où :
l'appareil de mesure de puissance (52) est configuré pour déterminer une moyenne d'un carré d'une magnitude d'un signal amplifié (51) sur la période de temps prédéterminée.

5. La station de base selon la revendication 4, où :
l'appareil de mesure de puissance (52) est couplé à une sortie de l'amplificateur (38) et est configuré pour mesurer une puissance du signal amplifié (51) ; et
le processeur (54) est configuré pour déterminer le niveau d'écrêtage du limiteur de signal réglable (50) sur la base de la puissance mesurée du signal amplifié (51).

6. La station de base selon la revendication 5, où le processeur (54) est configuré pour réduire d'un gain de l'amplificateur (38) la sortie de l'appareil de mesure de puissance (52).

7. La station de base selon la revendication 1, où :
l'appareil de mesure de puissance (52) est configuré pour approximer une variance du signal transmis (49, 51) sur la période de temps prédéterminée ; et
le processeur (54) est configuré pour déterminer une racine carrée du signal transmis comme écart standard.

8. La station de base selon la revendication 7, où l'écart standard est deux fois un niveau d'écrêtage du limiteur de signal réglable (50).

9. La station de base selon la revendication 1, où le processeur (54) est configuré pour outrepasser un niveau d'écrêtage déterminé du limiteur de signal réglable (50).

10. La station de base selon la revendication 1, où le processeur (54) est configuré pour commander un gain de l'amplificateur (38).

11. La station de base selon la revendication 10, où le gain de l'amplificateur (38) est réglé pour empêcher l'amplificateur (38) d'entrer dans une plage de fonctionnement non linéaire.
